# FASCICULE DE BREVET EUROPEEN

(11) **EP 3 344 024 B1**
(45) Date de publication et mention de la délivrance du brevet: **06.12.2023**
(21) Numéro de dépôt: 17210537.1
(22) Date de dépôt: 22.12.2017
(51) Int. Cl.: H05K 7/14, H01L 25/07, H01L 27/02, H02M 3/155

(54) **MODULE DE COMMUTATION TRIPHASÉ**
DREHSTROM-UMSCHALTMODUL
THREE-PHASE SWITCHING MODULE

(30) Priorité: 29.12.2016 FR 1663513
(43) Date de publication de la demande: 04.07.2018
(73) Titulaire: Commissariat à l'Energie Atomique et aux Energies Alternatives, 75015 Paris (FR)
(72) Inventeur: LEFEVRE, Guillaume, 73100 AIX LES BAINS (FR)
(74) Mandataire: Cabinet Beaumont

(56) Documents cités:
- EP-A2- 2 367 281
- US-A1- 2013 336 033
- US-B1- 6 501 172

## Description

### Domaine

La présente description concerne de façon générale les systèmes électroniques de conversion d'énergie et plus particulièrement, la réalisation d'un onduleur de courant triphasé. La présente description concerne plus précisément l'architecture d'un convertisseur statique de puissance destiné à des applications de type onduleur (CC-CA).

### Exposé de l'art antérieur

Un convertisseur statique de puissance continu CC - alternatif CA (onduleur) triphasé à deux niveaux est généralement basé sur deux ensembles de trois (ou trois ensembles de deux) interrupteurs électroniques, typiquement des transistors MOS de puissance (MOSFET) associés à des diodes.

On distingue les onduleurs de tension dans lesquels les transistors sont directement en série deux à deux et chaque transistor est équipé d'une diode en antiparallèle, et les onduleurs de courant dans lesquels chaque transistor est en série avec une diode pour constituer un interrupteur bidirectionnel en tension et unidirectionnel en courant. Le document US 6 501 172 B1 divulgue un onduleur de tension conventionnel ainsi qu'un module de commutation triphasé incluant trois cellules de commutation identiques pour un tel onduleur de tension. 1

La présente description vise les onduleurs de courant, tels que divulgués, par exemple, dans les documents US 2013/336033 A1 et EP 2 367 281 A2.

Dans des applications de puissance, les transistors et les diodes sont généralement réalisés individuellement sous la forme de composants discrets ou puces nues. Chaque interrupteur à commutation commandée (transistor) ou à commutation spontanée (diode) est réalisé sous la forme d'une puce individuelle à base de matériaux semiconducteurs et les différentes puces sont ensuite montées sur un substrat (circuit imprimé ou Printed Circuit Board - PCB, cuivre à soudure directe ou Direct Bond Copper - DBC métallique, substrat métallique isolé ou Insulated Métal Substrate - IMS, etc.) puis électriquement connectées pour réaliser la fonction d'onduleur de courant triphasé.

Il existe un besoin d'améliorer les onduleurs de courant triphasé et en particulier leur architecture spatiale.

### Résumé

Un mode de réalisation pallie tout ou partie des inconvénients des onduleurs de courant triphasé.

Un mode de réalisation propose une solution permettant d'homogénéiser les contraintes de fonctionnement entre les différents interrupteurs d'un onduleur de courant triphasé.

Un mode de réalisation propose une solution adaptée à la réalisation d'un onduleur de courant.

Ainsi, l'invention concerne un module de commutation triphasé incluant trois cellules de commutation identiques, selon l'une des revendications indépendantes 1 ou 2.

Selon un mode de réalisation, le deuxième niveau comporte en outre trois troisièmes zones conductrices, chacune reliée par des vias à une deuxième et a une quatrième zone conductrice du premier niveau.

Selon un mode de réalisation, ladite troisième zone conductrice du premier niveau à une forme de Y, chaque branche recevant un desdits deuxièmes interrupteurs.

Selon un mode de réalisation, le module s'inscrit dans une forme triangulaire.

Selon un mode de réalisation, un troisième niveau du substrat, entre les premier et deuxième niveaux, comporte :
des premières zones conductrices à l'aplomb de chaque premier interrupteur ; et
une deuxième zone conductrice s'étendant sous les trois deuxièmes interrupteurs.

Selon un mode de réalisation, un quatrième niveau du substrat entre les deuxième et troisième niveaux, comporte :
des premières zones conductrices à l'aplomb de chaque premier interrupteur ; et
une deuxième zone conductrice s'étendant sous les trois deuxièmes interrupteurs.

Selon un mode de réalisation, les premières zones conductrices du premier niveau reçoivent des bornes de conduction respectives des deuxièmes interrupteurs, le premier niveau comportant en outre trois troisièmes zones conductrices de réception de fils de raccordement à des bornes de conduction avant respectives des deuxièmes interrupteurs.

Selon un mode de réalisation, les deuxièmes zones conductrices du premier niveau sont chacune reliées, par des vias, à une desdites premières zones conductrices du deuxième niveau.

Selon un mode de réalisation, lesdites premières zones conductrices du deuxième niveau décrivent un anneau hexagonal.

Selon un mode de réalisation, le module s'inscrit dans une forme hexagonale.

Selon un mode de réalisation, lesdits interrupteurs sont des transistors.

Selon un mode de réalisation, le substrat est un substrat métallique isolé, multiniveaux, de préférence sur céramique.

Selon un mode de réalisation, le substrat est un circuit imprimé multiniveaux.

Un mode de réalisation prévoit un onduleur de courant triphasé, comportant deux modules.

Selon un mode de réalisation, les cellules des deux modules sont électriquement connectées deux à deux, les noeuds d'interconnexion définissant trois bornes de phase.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1 est une représentation schématique et sous forme de blocs d'un onduleur triphasé du type auquel s'appliquent les modes de réalisation décrits ;
la figure 2 représente un schéma électrique d'un onduleur de courant triphasé ;
la figure 3 est une représentation schématique d'une architecture usuelle d'un module de commutation d'un onduleur de courant triphasé ;
la figure 4A représente, de façon très schématique, un mode de réalisation d'un premier module d'onduleur de courant triphasé dans un premier niveau d'un substrat métallique isolé ;
la figure 4B représente de façon très schématique un mode de réalisation d'un deuxième niveau du substrat métallique isolé du premier module de la figure 4A ;
la figure 4C représente de façon très schématique les deux niveaux superposés, c'est-à-dire le module terminé ;
la figure 5A représente, de façon très schématique, un mode de réalisation d'un deuxième module d'onduleur de courant triphasé dans un premier niveau d'un substrat métallique isolé ;
la figure 5B représente, de façon très schématique, un mode de réalisation d'un deuxième niveau du substrat métallique isolé du deuxième module de la figure 5A ;
la figure 5C représente, de façon très schématique, les deux niveaux superposés, c'est-à-dire le module terminé ;
la figure 6A représente, de façon très schématique, un autre mode de réalisation d'un premier niveau de substrat métallique isolé dans lequel est réalisé un module d'onduleur de courant triphasé ;
la figure 6B représente, de façon très schématique, un autre mode de réalisation d'un deuxième niveau de substrat métallique isolé dans lequel est réalisé un module d'onduleur de courant triphasé selon la figure 6A ;
la figure 7 représente le schéma électrique d'un module dans lequel chaque cellule est formée de deux transistors MOS en série ;
la figure 8A représente, de façon très schématique, un mode de réalisation d'un premier niveau d'un substrat métallique isolé quadri-niveaux dans lequel est réalisé un module d'onduleur de courant triphasé ;
la figure 8B représente, de façon très schématique, un mode de réalisation d'un troisième niveau du substrat métallique isolé quadri-niveaux dans lequel est réalisé un module d'onduleur de courant triphasé selon la figure 8A ;
la figure 8C représente, de façon très schématique, un mode de réalisation d'un quatrième niveau du substrat métallique isolé quadri-niveaux dans lequel est réalisé un module d'onduleur de courant triphasé selon la figure 8A ; et
la figure 8D représente, de façon très schématique, un mode de réalisation d'un deuxième niveau du substrat métallique isolé quadri-niveaux dans lequel est réalisé un module d'onduleur de courant triphasé selon la figure 8A.

### Description détaillée

Par souci de clarté, seuls les éléments qui sont utiles à la compréhension des modes de réalisation décrits ont été représentés et seront détaillés. En particulier, la commande d'un convertisseur de puissance basé sur les onduleurs triphasés décrits n'a pas été détaillée, les modes de réalisation décrits étant compatibles avec les procédés industriels de fabrication et circuits de commande usuels. De plus, la constitution et réalisation des circuits en amont et en aval des onduleurs triphasés décrits n'ont pas non plus été détaillées, les modes de réalisation décrits étant compatibles avec les applications usuelles de tels onduleurs triphasés. Il est à noter que, sur les figures, les éléments structurels et/ou fonctionnels communs aux différents modes de réalisation peuvent présenter les mêmes références et peuvent disposer de propriétés structurelles, dimensionnelles et matérielles identiques. Sauf précision contraire, les expressions "approximativement", "sensiblement" et "de l'ordre de" signifient à 10 % près, de préférence à 5 % près, ou à 10° près, de préférence à 5° près.

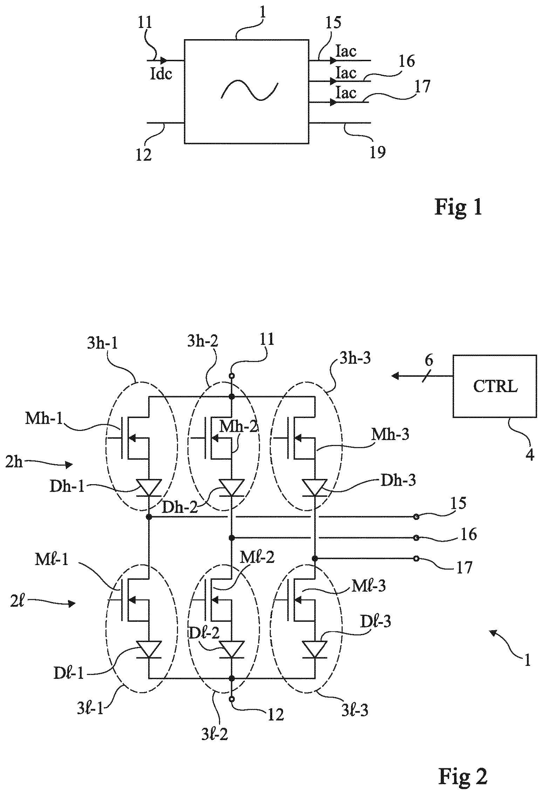

La figure 1 est une représentation schématique et sous forme de blocs d'un onduleur triphasé du type auquel s'appliquent les modes de réalisation décrits.

La fonction d'un onduleur triphasé 1 est de convertir un courant continu Idc circulant entre deux bornes 11 et 12 d'entrée en un courant alternatif triphasé Iac sur des bornes de sortie 15, 16, 17 et 19. Les bornes 15, 16 et 17 représentent les bornes des différentes phases et la borne 19 représente la borne de neutre optionnelle.

La figure 2 représente un schéma électrique d'un onduleur de courant triphasé.

L'onduleur 1 comporte deux modules de commutation 2h et 2l de structures internes similaires. Chaque module 2 comporte trois cellules de commutation, impliquant de manière cyclique deux des trois interrupteurs, respectivement 3h-1, 3h-2, 3h-3 et 3l-1, 3l-2, 3l-3 identiques et chacune constituée d'un transistor MOS (à canal N) respectivement Mh-1, Mh-2, Mh-3, Ml-1, Ml-2, Ml-3 en série avec une diode, respectivement Dh-1, Dh-2, Dh-3, Dl-1, Dl-2, Dl-3. Les drains des transistors Mh-1, Mh-2 et Mh-3 sont interconnectés à la borne 11 d'application d'un premier potentiel de la source de courant Idc. Les sources des transistors Mh-1, Mh-2 et Mh-3 sont respectivement connectées aux anodes des diodes Dh-1, Dh-2 et Dh-3, dont les cathodes sont connectées respectivement aux bornes 15, 16 et 17 des trois phases de tension alternative. Les drains des transistors Ml-1, Ml-2, Ml-3 sont respectivement connectés aux bornes 15, 16 et 17. Les sources des transistors Ml-1, Ml-2 et Ml-3 sont respectivement connectées aux anodes des diodes Dl-1, Dl-2 et Dl-3, dont les cathodes sont interconnectées à la borne 12 d'application d'un deuxième potentiel de la source de courant Idc.

Les grilles des transistors Mh-1, Mh-2, Mh-3, Ml-1, Ml-2, Ml-3 sont individuellement connectées à un circuit de commande 4 (CTRL) chargé d'organiser la commutation des différentes cellules pour générer un courant alternatif Iac triphasé. Dans un onduleur de courant, la circulation du courant s'effectue successivement dans chacune des cellules de commutation (par exemple 3h-1/3h-2, 3h-1/3h-3, 3h-2/3h-3) d'un premier module conjointement à chacune des cellules de commutation (par exemple 3l-1/3l-2, 3l-1/3l-3, 3l-2/3l-3) de l'autre module. On obtient ainsi les 9 combinaisons permettant de générer le courant alternatif triphasé avec les déphasages appropriés. La commande d'un tel onduleur de courant est usuelle.

Dans la présente description, on identifie par la lettre « h » ou « l » complétant une même référence numérique le module haut ou bas de l'onduleur de courant triphasé auquel appartient l'élément identifié par la référence numérique. Par ailleurs, on complète les références par « -1 », « -2 » ou « -3 » pour identifier la branche de commutation (représentant la phase de la tension alternative) à laquelle appartient l'élément identifié par la référence numérique. Ces compléments de référence pourront être omis lorsqu'une distinction n'a pas besoin d'être faite pour les besoins de l'exposé.

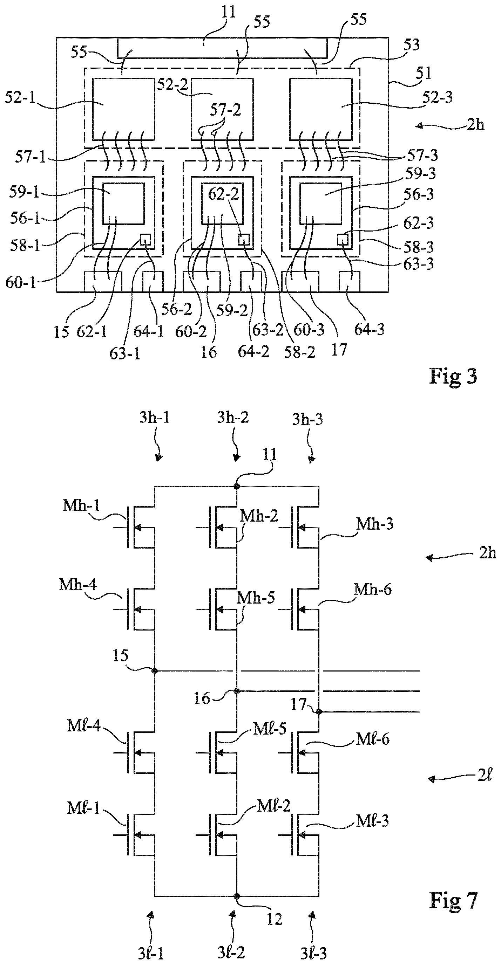

La figure 3 est une représentation schématique d'une architecture usuelle d'un module de commutation d'un onduleur de courant triphasé.

Dans les applications de puissance visées par la présente description, les transistors et diodes sont réalisés sous la forme de composants verticaux en matériaux semiconducteurs montés sur un plan (substrat métallique ou de circuit imprimé) 51.

Dans l'exemple de la figure 3, on considère un module haut 2h, dont les diodes et transistors sont inversés par rapport à la figure 2. Ce sont donc les anodes des diodes Dh-1, Dh-2, Dh-3 qui sont interconnectées à la borne 11. Les trois diodes Dh-1, Dh-2 et Dh-3 sont réalisées individuellement sur des substrats de type P et les cathodes sont réalisées par des régions de type N dans ces substrats. Les électrodes d'anode, généralement réalisées sous la forme d'une métallisation face arrière des puces formant les diodes Dh-1, Dh-2, Dh-3, sont rapportées sur une zone conductrice 53 (typiquement un plan conducteur métallique) d'un substrat 51, dans cet exemple un substrat métallique isolé. Une métallisation définissant la borne 11 est raccordée au plan 53 par un ou plusieurs fils 55. Les transistors Mh-1, Mh-2 et Mh-3 sont également réalisés individuellement sous forme de puces 56-1, 56-2 et 56-3. L'électrode de drain de chaque transistor, généralement réalisée sous la forme d'une métallisation en face arrière de la puce, est rapportée sur une zone conductrice 58-1, 58-2 et 58-3 respectivement du substrat métallique isolé 51. Les électrodes de cathode correspondant à des métallisations face avant 52-1, 52-2 et 52-3 des puces formant les diodes Dh-1, Dh-2 et Dh-3 sont respectivement électriquement connectées aux zones 58-1, 58-2 et 58-3 par un ou plusieurs fils 57-1, 57-2, 57-3. L'électrode de source de chaque transistor Mh-1, Mh-2, Mh-3 correspond à un contact métallique face avant, respectivement 59-1, 59-2, 59-3, connecté par un ou plusieurs fils 60-1, 60-2, 60-3 à un contact du substrat métallique isolé, définissant une borne, respectivement 15, 16, 17. Les grilles des transistors Mh-1, Mh-2 et Mh-3 sont reprises en face avant des puces par des contacts 62-1, 62-2 et 62-3, connectés individuellement par un ou plusieurs fils 63-1, 63-2, 63-3, à des contacts respectifs du substrat métallique isolé 51, définissant des bornes 64-1, 64-2, 64-3 destinées à être raccordées au circuit de commande 4 (figure 2) .

Une architecture telle qu'illustrée en figure 3 dans laquelle les puces sont juxtaposées engendre des contraintes de fonctionnement, thermiques et électriques, différentes selon les phases de fonctionnement, ce qui nuit à sa fiabilité.

Par ailleurs, on assiste à un déséquilibre entre les différentes mailles de conduction, ce qui nuit également au fonctionnement.

Les modes de réalisation qui vont être décrits partent d'une nouvelle analyse basée sur l'architecture ou la disposition des différentes cellules de commutation sur un substrat à zones métalliques, par exemple un substrat métallique isolé.

On prévoit notamment de rendre les contraintes électriques et thermiques subies par les différentes puces du convertisseur, identiques quelle que soit la phase. Ainsi, on homogénéise le vieillissement, ce qui accroît la fiabilité des onduleurs de courant.

Plus particulièrement, on prévoit d'utiliser un substrat métallique isolé multicouches (au moins deux) et de disposer les éléments constitutifs de chaque cellule de commutation avec, dans le plan, une symétrie de révolution d'ordre 3 par rapport au centre de la structure. Plus précisément, les trois cellules d'un module sont disposées dans des branches d'une structure en étoile ou en Y sur un premier niveau (dit arbitrairement supérieur) du substrat métallique isolé dans lequel sont définies des zones métallisées et des interconnexions sont effectuées dans au moins un deuxième niveau du substrat métallique isolé dans lequel sont également définies des zones métallisées, la liaison entre des zones métallisées d'un niveau à un autre étant effectuée par des vias conducteurs.

Pour simplifier la représentation des figures et l'exposé qui suit, seules les zones métallisées des différents niveaux des substrats métalliques isolés ont été représentées. Ces zones sont bien entendu portées par un support isolant et les différents niveaux sont séparés par des niveaux isolants.

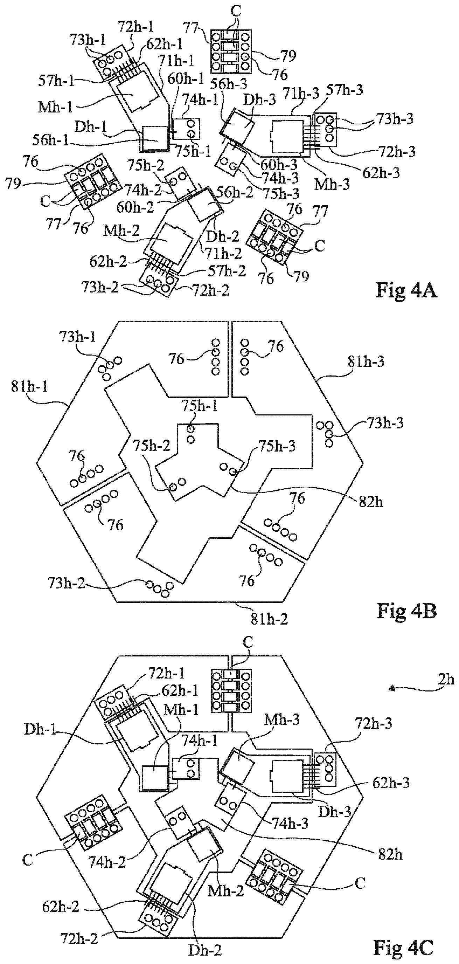

La figure 4A représente, de façon très schématique, un mode de réalisation d'un premier module 2h d'un onduleur de courant triphasé dans un premier niveau d'un substrat métallique isolé.

La figure 4B représente de façon très schématique un mode de réalisation d'un deuxième niveau du substrat métallique isolé du premier module de la figure 4A.

La figure 4C représente de façon très schématique les deux niveaux superposés, c'est-à-dire le module 2h terminé.

Dans l'exemple des figures 4A à 4C, les diodes des cellules sont disposées au départ des branches du Y (vers le centre) et les transistors sont disposés vers les extrémités libres des branches du Y. Par ailleurs, on suppose un schéma électrique dans lequel les positions respectives des diodes et transistors sont inversées par rapport au schéma électrique de la figure 2. En d'autres termes, dans le module haut 2h, les anodes des diodes sont interconnectées à la borne 11 et les sources des transistors sont connectées aux bornes respectives 15, 16 et 17.

Comme précédemment, les diodes et transistors sont réalisés individuellement sous forme de puces discrètes de composants verticaux en matériaux semiconducteurs.

Dans le premier niveau (figure 4A), on réalise des premières zones conductrices 71h-1, 71h-2, 71h-3 de forme approximativement rectangulaire de réception de bornes de conduction arrière (par exemple les drains) des transistors Mh-1, Mh-2, Mh-3 (correspondant à des métallisations face arrière des puces formant ces transistors) et des bornes de conduction arrière (par exemple les cathodes) de chaque puce 56h-1, 56h-2, 56h-3, formant les diodes respectives Dh-1, Dh-2, Dh-3.

Des deuxièmes zones conductrices 72h-1, 72h-2, 72h-3 sont réalisées aux extrémités externes respectives des premières zones 71. Les zones 72 sont destinées à recevoir chacune un ou plusieurs fils 57h-1, 57h-2, 57h-3 de raccordement des bornes de conduction avant (par exemple les sources) des transistors Mh-1, Mh-2 et Mh-3 (correspondant à des métallisations face avant des puces formant ces transistors). Les zones 72 sont connectées, par des vias 73h-1, 73h-2, 73h-3 à des premières zones 81h-1, 81h-2, 81h-3 (figure 4B) du deuxième niveau du substrat métallique isolé.

Des troisièmes zones conductrices 74h-1, 74h-2, 74h-3 sont réalisées dans la région centrale à proximité des puces des diodes respectives Dh-1, Dh-2, Dh-3. Ces zones 74 sont destinées à recevoir chacune un ou plusieurs fils 60h-1, 60h-2, 60h-3 de raccordement des bornes de conduction avant (par exemple les anodes) des diodes Dh-1, Dh-2, Dh-3. Ces anodes sont destinées à être interconnectées (à la borne 11). Pour cela, les zones 74 sont connectées, par des vias 75h-1, 75h-2, 75h-3 à une deuxième zone 82-h centrale (figure 4B) du deuxième niveau du substrat métallique isolé.

Les contacts de grilles 62h-1, 62h-2 et 62-3 des transistors Mh-1, Mh-2, Mh-3 sont accessibles pour un raccordement, par exemple par fils à des circuits de commande qui, comme on le verra par la suite, sont de préférence placés à proximité.

Dans le deuxième niveau (figure 4B), la réalisation des zones 81h et 82h dépend des positions respectives de zones du premier niveau. Toutefois, comme pour les zones conductrices du premier niveau, les zones conductrices du deuxième niveau respectent, dans le plan, une symétrie de révolution d'ordre 3 par rapport au centre de la structure. En d'autres termes, l'ensemble de la structure présente sensiblement une symétrie de révolution de 120°.

Dans l'exemple de la figure 4B, le deuxième niveau décrit un hexagone. Les zones 81 correspondent à trois zones 81h-1, 81h-2, 81h-3 métallisées identiques, ayant chacune la forme d'une portion d'une bande annulaire hexagonale, chaque zone étant séparée de ses deux zones voisines. La zone centrale 82h a une forme, ici approximativement en étoile, à l'aplomb des trois zones 74h-1, 74h-2 et 74h-3 du premier niveau. Les zones 81h-1, 81h-2, 81h-3 définissent respectivement les bornes 15, 16 et 17. La zone 82h définit la borne 11.

Cette disposition permet d'intégrer, dans l'exemple représenté, côté face supérieure, des éléments capacitifs C de découplage reliant électriquement les bornes 15, 16, et 17 deux à deux. Pour cela, on réalise dans le premier niveau, à la verticale des extrémités des zones 81, des zones 77 et 79 destinées à recevoir les électrodes respectives des condensateurs C et reliées par des vias 76 aux zones 81 sous-jacentes.

En variante, les éléments capacitifs C sont soudés directement sur la deuxième face du substrat métallique isolé (dans ce cas les zones 77 et 79 ne sont pas nécessaires). La réalisation illustrée par les figures 4A à 4C permet cependant de conserver la face arrière pour un radiateur.

De préférence, on prévoit dans le deuxième niveau, à l'aplomb des diodes et des transistors, des découpes des zones conductrices susceptibles d'être présentes afin d'éviter que les puces soient à l'aplomb de zones conductrices du deuxième niveau.

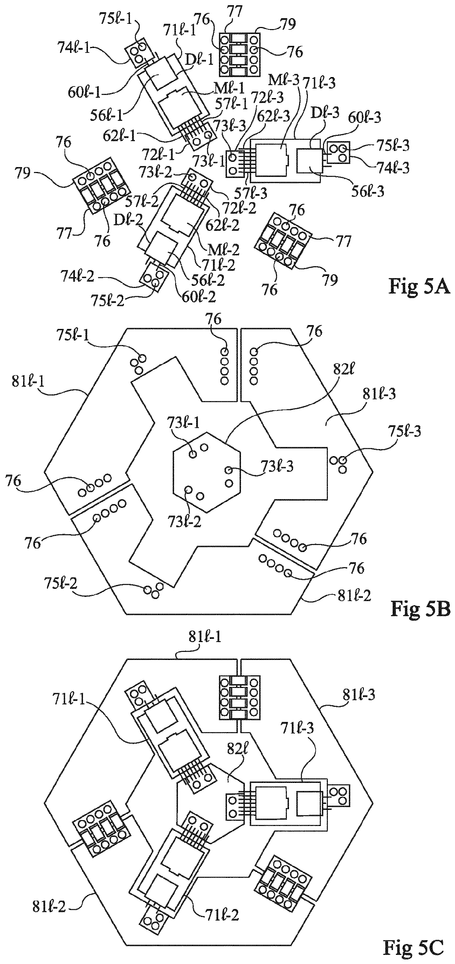

La figure 5A représente, de façon très schématique, un mode de réalisation d'un deuxième module 2l d'onduleur de courant triphasé dans un premier niveau d'un substrat métallique isolé.

La figure 5B représente, de façon très schématique, un mode de réalisation d'un deuxième niveau du substrat métallique isolé du deuxième module de la figure 5A.

La figure 5C représente, de façon très schématique, les deux niveaux superposés, c'est-à-dire le module 21 terminé.

Ici, les diodes des cellules sont disposées vers les extrémités des branches du Y et les transistors sont disposés vers le centre. Ici encore, on suppose un schéma électrique dans lequel les positions respectives des diodes et transistors sont inversées par rapport au schéma électrique de la figure 2. En d'autres termes, dans le module bas 21, les sources des transistors sont interconnectées à la borne 12 et les anodes des diodes sont connectées aux bornes respectives 15, 16 et 17. Toutefois, tout autre arrangement pourra être envisagé pourvu de respecter la symétrie de révolution d'approximativement 120°. En effet, les positions respectives des transistors et diodes dans chacun des modules peuvent être inversées.

Dans le premier niveau (figure 5A), on réalise des premières zones conductrices 71l-1, 71l-2, 71l-3 de forme approximativement rectangle de réception des électrodes de cathode en face arrière de chaque puce 56l-1, 56l-2, 56l-3 formant les diodes Dl-1, Dl-2, Dl-3 et des contacts de drain des transistors respectifs Ml-1, Ml-2, Ml-3.

Des deuxièmes zones conductrices 74l-1, 74l-2, 74l-3 sont réalisées aux extrémités externes respectives des premières zones 71 à proximité des puces 56l-1, 56l-2, 56l-3 des diodes respectives Dl-1, Dl-2, Dl-3. Ces zones 74 sont destinées à recevoir chacune un ou plusieurs fils 60l-1, 60l-2, 60l-3 de raccordement des anodes des diodes Dl-1, Dl-2, Dl-3. Ces anodes sont destinées à être individuellement connectées aux bornes respectives 15, 16 et 17. Pour cela, les zones 74 sont connectées, par des vias 75l-1, 75l-2, 75l-3 à des premières zones 81l-1, 81l-2, 81l-3 (figure 5B) du deuxième niveau de substrat métallique isolé.

Des troisièmes zones conductrices 72l-1, 72l-2, 72l-3 sont réalisées dans la région centrale à proximité des puces des transistors respectifs Ml-1, Ml-2, Ml-3. Les zones 72 sont destinées à recevoir chacune un ou plusieurs fils 57l-1, 57l-2, 571-3 de raccordement des sources des transistors. Ces sources sont destinées à être interconnectées (à la borne 12). Pour cela, les zones 72 sont connectées, par des vias 73l-1, 73l-2, 73l-3 à une deuxième zone centrale 821 (figure 5B) du deuxième niveau de substrat métallique isolé.

Les contacts de grilles 621-1, 621-2 et 621-3 des transistors Ml-1, Ml-2, Ml-3 sont accessibles pour un raccordement, par exemple par fils à des circuits de commande, de préférence placés à proximité.

Dans le deuxième niveau (figure 5B), la réalisation des zones 81 et 82 dépend des positions respectives des zones du premier niveau. Toutefois, ici encore, comme pour les zones conductrices du premier niveau, les zones conductrices du deuxième niveau respectent, dans le plan, une symétrie de révolution d'ordre 3 par rapport au centre de la structure.

Dans l'exemple de la figure 5B, les zones 81 correspondent à trois zones 811-1, 81l-2, 81l-3 métallisées identiques, ayant chacune la forme d'une portion d'une bande annulaire hexagonale, chaque zone étant séparée de ses deux zones voisines. La zone centrale 82l a une forme, ici approximativement également hexagonale, à l'aplomb des trois zones 721-1, 721-2 et 721-3 du premier niveau. Les zones 811-1, 811-2, 81l-3 définissent respectivement les bornes 15, 16 et 17. La zone 82l définit la borne 12.

Comme pour le module 2h, on peut intégrer, côté face supérieure, des éléments capacitifs C de découplage reliant électriquement les bornes 15, 16, et 17 deux à deux. Pour cela, on réalise dans le premier niveau, à la verticale des extrémités des zones 81, des zones respectivement 77 et 79 destinées à recevoir les électrodes respectives des condensateurs C et reliées par des vias 76 aux zones 81 sous-jacentes. Là encore, les éléments capacitifs C peuvent en variante être soudés directement sur la deuxième face du substrat métallique isolé.

Toujours comme pour le module 2h, on prévoit de préférence dans le deuxième niveau, à l'aplomb des diodes et des transistors, des découpes des zones conductrices susceptibles d'être présentes afin d'éviter que les puces soient à l'aplomb de zones conductrices du deuxième niveau.

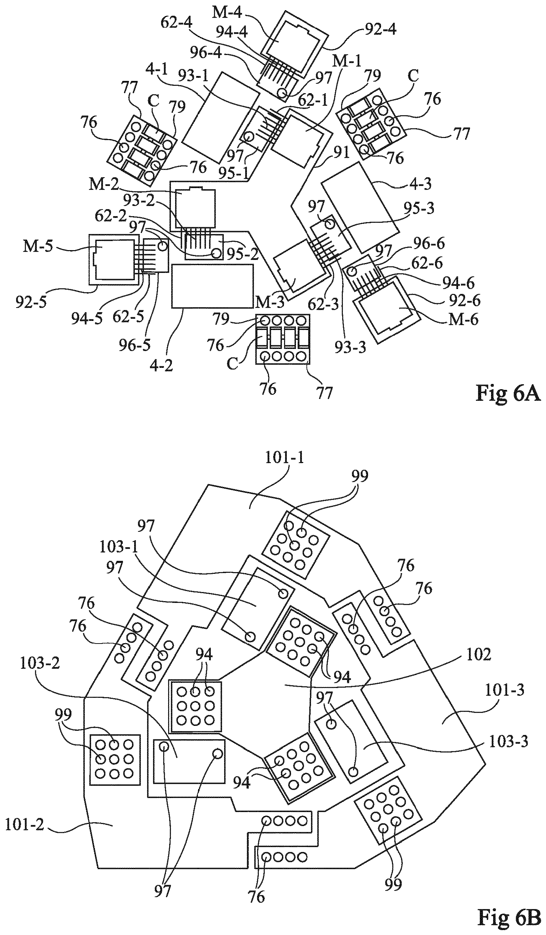

Les figures 6A et 6B représentent, de façon schématique, un autre mode de réalisation d'un module d'un onduleur de courant triphasé sur un substrat métallique isolé bi-niveaux.

Ce mode de réalisation illustre, non seulement un agencement différent des composants et des zones conductrices mais également un mode de réalisation selon lequel tous les interrupteurs sont des transistors. Par conséquent, l'arrangement des zones conductrices des figures 6A et 6B peut servir indifféremment pour réaliser un module haut 2h ou un module bas 21 d'un onduleur de courant triphasé.

La figure 7 représente le schéma électrique d'un module dans lequel chaque cellule est formée de deux transistors MOS en série.

Dans cet exemple, les transistors M-1, M-2, M-3 de chaque cellule sont interconnectés par leurs sources respectives à la source de l'autre transistor M-4, M-5, M-6 de la cellule. Les drains des transistors M-1, M-2 et M-3 sont interconnectés à la borne 11 ou 12 selon que le module est monté en module haut ou bas, et les drains des transistors M-4, M-5 et M-6 définissent les bornes respectives 15, 16 et 17.

Dans le premier niveau (figure 6A), on réalise des premières zones conductrices 92-4, 92-5, 92-6 de forme approximativement rectangle (ou carrée) de réception des contacts (drains) de face arrière des transistors M-4, M-5, M-6. On suppose ici des transistors à drain face arrière. On réalise également une troisième zone conductrice 91 approximativement en étoile ou en Y dont chaque branche (de préférence son extrémité libre) reçoit le contact (de drain) de face arrière d'un des transistors M-1, M-2, M-3. Les centres des puces des transistors d'une même cellule sont approximativement sur un même rayon de cercle fictif reliant les centres des puces des transistors M-1, M-2, M-3 entre eux et les centres des puces des transistors M-4, M-5, M-6 entre eux. Les premières zones 92 sont connectées, par un ensemble de vias 99 disposés sous la puce qu'ils reçoivent à des premières zones respectives 101-1, 101-2, 101-3, du deuxième niveau (figure 6B) décrivant chacune une portion d'une forme en anneau approximativement triangulaire. La troisième zone 91 est connectée, par des ensembles de vias 94, disposés sous les puces des transistors M-1, M-2, M-3, à une deuxième zone centrale 102, approximativement en étoile ou en Y, du deuxième niveau.

Des deuxièmes 96-4, 96-5, 96-6 et quatrièmes 95-1, 95-2, 95-3 zones conductrices sont réalisées dans le premier niveau, à proximité des premières et deuxièmes zones respectivement, et sont destinées à recevoir chacune un ou plusieurs fils 94-4, 94-5, 94-6, respectivement 93-1, 93-2, 93-3, de raccordement des contacts de source des transistors M-4, M-5, M-6, respectivement M-1, M-2, M-3. Les zones 95 et 96 sont connectées, deux à deux, par des vias 97, à trois zones approximativement rectangulaires 103-1, 103-2 et 103-3 du deuxième niveau. L'interconnexion des zones 95 et 96 par le deuxième niveau préserve un accès facile aux grilles 62-1, 62-2, 62-3, 62-4, 62-5, 62-6. En variante, on pourra prévoir une découpe particulière des zones 95 et 96 et un tracé adapté des pistes de connexion (non représentées) des grilles aux circuits de commande 4-1, 4-2, 4-3 pour interconnecter les sources dans le premier niveau.

Comme pour les modes de réalisation précédents, on intègre, côté face supérieure, des éléments capacitifs C reliant électriquement les bornes 15, 16, et 17 deux à deux. Pour cela, on réalise dans le premier niveau, à la verticale des extrémités des zones 101, des zones, respectivement 77 et 79 destinées à recevoir les électrodes respectives des condensateurs C et reliées par des vias 76 aux zones 101 sous-jacentes. Dans l'exemple des figures 6A et 6B, les zones 77 et 79 sont agencées parallèlement aux branches du triangle défini par les zones 81 et non perpendiculairement (radialement par rapport au centre de la structure) comme dans les figures précédentes. Les deux réalisations sont toutefois possibles.

Un avantage du mode de réalisation des figures 6A et 6B est qu'il réduit le couplage capacitif entre les conducteurs de puissance (drain, source pour des transistors MOS ou émetteur, collecteur pour des transistors bipolaires ou IGBT) et les circuits de commande des grilles des interrupteurs commandés.

Un autre avantage est que la surface de la zone centrale est accrue ce qui permet de diminuer l'inductance de maille.

Un autre avantage est que cela participe à réduire les émissions de mode commun liées aux couplages capacitifs entre les potentiels des bornes 11 et 12 et la terre en cas de substrat métallique isolé directement refroidi par un radiateur.

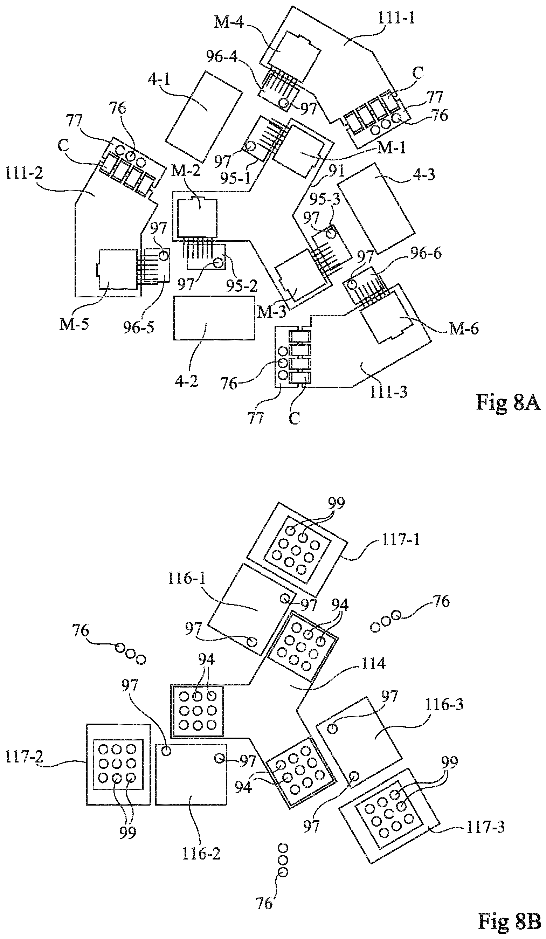

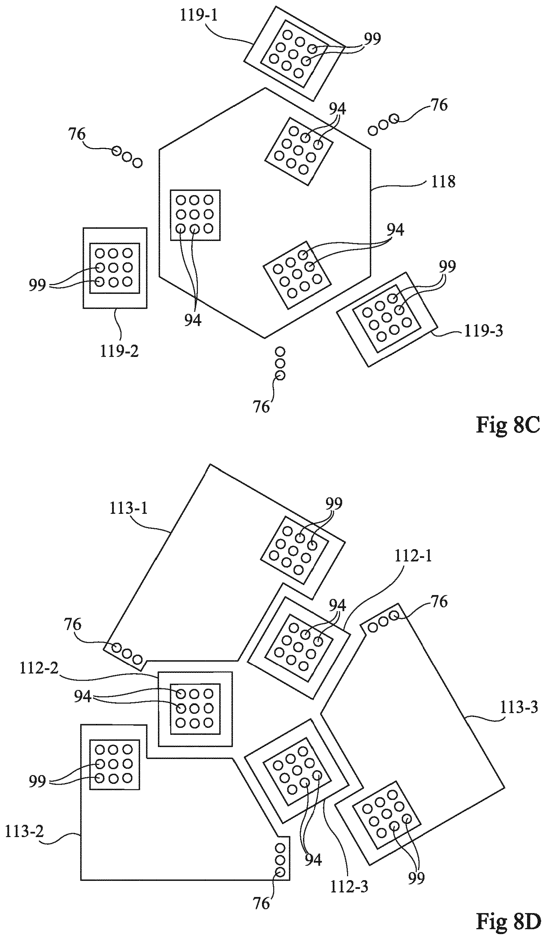

Les figures 8A, 8B, 8C et 8D illustrent, de façon schématique, un mode de réalisation d'un module d'un onduleur de courant triphasé sur un substrat métallique isolé quadri-niveaux. La figure 8A représente le premier niveau (supérieur). La figure 8D représente le deuxième niveau (inférieur). Les figures 8B et 8C représentent deux niveaux intermédiaires, dénommés arbitrairement troisième et quatrième niveaux.

Le premier niveau de la figure 8A est similaire à celui de la figure 6A. La seule différence est que les zones, ici désignées 111-1, 111-2, 111-3, portant les transistors M-4, M-5 et M-6 se prolongent en direction de la zone 77 de la cellule voisine de façon à recevoir une première électrode des capacités C, l'autre électrode étant reçue par la zone 111. Dans l'exemple de la figure 8A, les zones 77 sont radiales au centre de la structure.

Le deuxième niveau (figure 8D) correspondant à la face arrière comporte au centre trois deuxièmes zones conductrices indépendantes 112-1, 112-2, 112-3 à l'aplomb des transistors M-1, M-2, M-3. Ces zones sont connectées par les vias 94 à la zone 91 sous les transistors M-1, M-2, M-3 (en traversant le ou les niveaux intermédiaires). Ce deuxième niveau comporte en outre trois premières zones 113-1, 113-2, 113-3 connectant respectivement, comme les zones 101 de la figure 6B, la face arrière de chaque puce de transistor M-4, M-5, M-6 à la zone 77 de la cellule voisine (par les vias 76). On notera que les zones 112 peuvent être omises. Leur rôle est principalement de favoriser la liaison thermique avec un radiateur prévu en face arrière de l'ensemble de la structure.

Le troisième niveau (figure 8B) situé juste en-dessous du premier niveau comporte une zone conductrice centrale 114 identique à la zone 91 du premier niveau à travers laquelle passent les vias 94. Ce niveau comporte également trois zones conductrices 116-1, 116-2, 116-3 du type des zones 103 de la figure 6B, connectant par les vias 97, les zones conductrices 95 et 96 du premier niveau de chaque cellule. Le rôle de ces zones 116 est de constituer un plan de protection sous les circuits de commande 4-1, 4-2, 4-3. En outre, des zones conductrices 117-1, 117-2, 117-3 sont prévues à l'aplomb des transistors M-4, M-5, M-6 à travers lesquelles passent les vias 99. Un rôle du troisième niveau est de créer des plans conducteurs de protection sous les circuits de commande 4.

Le quatrième niveau (figure 8C), situé entre les troisième et deuxième niveaux, comporte une zone centrale 118, par exemple de forme hexagonale, à travers laquelle passent les vias 94. Ce niveau comporte en outre des zones 119-1, 119-2, 119-3 à travers lesquelles passent les vias 99. Le rôle de la zone 118 est de réduire l'inductance parasite liée aux connexions. En variante, la zone 118 peut avoir une forme triangulaire intégrant les régions des vias 94.

Un agencement des puces tel qu'illustré dans les modes de réalisation ci-dessus présente l'avantage d'homogénéiser le comportement électrique et thermique des différentes mailles de circulation de courant. En effet, la symétrie géométrique entre les différentes cellules entraîne que les trois mailles possibles 3h-1/3h-2, 3h-2/3h-3 et 3h-1/3h-3 pour le module haut 2h et les trois mailles possibles 3l-1/3l-2, 3l-2/3l-3 et 3l-1/3l-3 pour le module bas 2l présentent un même comportement électrique. En particulier, les impédances des différentes mailles de commutation utilisées sont identiques et les niveaux de surtension vus par les différents interrupteurs sont identiques. De plus, leur comportement thermique est également homogénéisé grâce à cette symétrie géométrique.

D'autres formes peuvent être prévues pour les zones métalliques du substrat métallique isolé de réception des cellules de commutation, pourvu de respecter, dans chaque niveau du substrat métallique isolé une symétrie de révolution d'ordre 3, c'est-à-dire un décalage d'environ 120 degrés, de préférence d'exactement 120 degrés, d'une cellule à l'autre autour du centre du plan dans lequel s'inscrit le module.

Un avantage des modes de réalisation qui ont été décrits est qu'il est désormais possible de réaliser un onduleur de courant triphasé dans lequel le comportement électrique et thermique des différentes mailles de commutation est identique.

Divers modes de réalisation et variantes ont été décrits. Certains modes de réalisation et variantes pourront être combinés et d'autres variantes et modifications apparaîtront à l'homme de l'art. En particulier, les zones métalliques du substrat utilisé sont bien entendu séparées les unes des autres de façon à être isolées électriquement. De plus, ces zones peuvent être reliées par des pistes conductrices ou fils à d'autres régions métalliques du substrat, en particulier pour raccorder l'onduleur à des circuits amont et aval. Par ailleurs, bien que l'on ait fait plus particulièrement référence à l'utilisation d'un substrat métallique isolé, le substrat sur lequel sont montés les composants peut être tout autre substrat adapté, par exemple un circuit imprimé, un substrat à cuivre à soudure directe, etc. De plus, chaque interrupteur peut en fait être formé de plusieurs interrupteurs en parallèle. Le choix des dimensions et du nombre de puces à assembler en parallèle pour réaliser chaque interrupteur d'un onduleur dépend de l'application et, entre autres, de la puissance de fonctionnement souhaitée.

En outre, bien que les modes de réalisation aient été décrits en relation avec des exemples appliqués à des cellules constituées d'un transistor MOS en série avec une diode ou de deux transistors MOS en série, ils se transposent à d'autres structures de cellules de commutation triphasées réalisant ou non un interrupteur bidirectionnel en tension et unidirectionnel ou bidirectionnel en courant, dans lesquelles des problèmes similaires se posent.

On notera que les deux modules d'un même onduleur de courant triphasé ne sont pas nécessairement appariés sur un même substrat métallique isolé (dans un même plan) mais peuvent être superposés avec interposition d'un isolant, en raccordant les bornes 15, 16 et 17 par des vias.

Enfin, la mise en oeuvre pratique des modes de réalisation et variantes qui ont été décrits est à la portée de l'homme de métier à partir des indications fonctionnelles données ci-dessus.

## Revendications

1. Module (2h ; 2l) de commutation triphasé incluant trois cellules de commutation (3h-1, 3h-2, 3h-3 ; 3l-1, 3l-2, 3l-3) identiques, comportant chacune un premier interrupteur (M) et un deuxième interrupteur (D ; M) électriquement en série entre une première borne (11, 12) commune aux trois cellules et une deuxième borne (15, 16, 17) propre à chaque cellule, le module comportant un substrat dont :
un premier niveau comporte :
trois premières zones conductrices (71h-1, 71h-2, 71h-3 ; 71l-1, 71l-2, 71l-3) de réception d'une borne de conduction arrière du premier interrupteur (M) et d'une borne de conduction arrière du deuxième interrupteur (D, M) de chaque cellule ; et
trois deuxièmes zones conductrices (72h-1, 72h-2, 72h-3 ; 74l-1, 74l-2, 74l-3) de réception de fils de raccordement à une borne de conduction avant dudit premier interrupteur (M) ; et
trois troisièmes zones conductrices (74h-1, 74h-2, 74-3) de réception de fils de raccordement à une borne de conduction avant dudit deuxième interrupteur (D, M) ; et
au moins un deuxième niveau comporte :
trois premières zones conductrices (81h-1, 81h-2, 81h-3 ; 81l-1, 81l-2, 81l-3) respectivement connectées aux troisièmes zones conductrices (72h-1, 72h-2, 72h-3) du premier niveau par des vias (73h-1, 73h-2, 73h-3), lesdites trois premières zones conductrices (81h 1, 81h 2, 81h 3 ; 81l 1, 81l 2, 811 3) étant destinées à être reliées aux deuxièmes bornes respectives (15, 16, 17) des cellules du module ; et
au moins une deuxième zone conductrice (82h ; 82l) connectée aux trois troisièmes zones conductrices (74h-1, 74h-2, 74-3) du premier niveau par des vias (75h-1, 75h-2, 75h-3), ladite deuxième zone (82h ; 82l) étant destinée à être reliée à la première borne (11, 12) du module,
les zones conductrices des différents niveaux respectant une symétrie de révolution d'ordre 3.

2. Module (2h ; 2l) de commutation triphasé incluant trois cellules de commutation (3h-1, 3h-2, 3h-3 ; 3l-1, 3l-2, 3l-3) identiques, comportant chacune un premier interrupteur (M-4, M-5, M-6) et un deuxième interrupteur (M-1, M-2, M-3) électriquement en série entre une première borne (11, 12) commune aux trois cellules et une deuxième borne (15, 16, 17) propre à chaque cellule, le module comportant un substrat dont :
un premier niveau comporte :
trois premières zones conductrices (92-4, 92-5, 92-6) de réception d'une borne de conduction arrière du premier interrupteur (M-4, M-5, M-6) de chaque cellule ; et
trois deuxièmes zones conductrices (96-4, 96-5, 96-6 ; 96-4, 96-5, 96-6) de réception de fils de raccordement à une borne de conduction avant dudit premier interrupteur (M-4, M-5, M-6) ; et
au moins une troisième zone conductrice (91) de réception d'une borne de conduction arrière du deuxième interrupteur (M-1, M-2, M-3) de chaque cellule ; et
trois quatrièmes zones conductrices (95-1, 95-2, 95-3) de réception de fils de raccordement à une borne de conduction avant dudit deuxième interrupteur (M-1, M-2, M-3) de chaque cellule ; et
au moins un deuxième niveau comporte :
trois premières zones conductrices (101-1, 101-2, 101-3 ; 113-1, 113-2, 113-3) respectivement à l'aplomb des premiers interrupteurs (M-4, M-5, M-6) et connectées aux trois premières zones conductrices (92-4, 92-5, 92-6) du premier niveau par des vias (99), lesdites premières zones (101-1, 101-2, 101,3 ; 113-1, 113-2, 113-3) étant destinées à être reliées aux deuxièmes bornes respectives (15, 16, 17) des cellules du module ; et
au moins une deuxième zone conductrice (102 ; 112-1, 112-2, 112-3) à l'aplomb des deuxièmes interrupteurs et connectées à la troisième zone conductrice (91) du premier niveau par des vias (94), ladite deuxième zone étant destinée à être reliée à la première borne (11, 12) du module,
les zones conductrices des différents niveaux respectant une symétrie de révolution d'ordre 3.

3. Module selon la revendication 2, dans lequel le deuxième niveau comporte en outre trois troisièmes zones conductrices (103-1, 103-2, 103-3), chacune reliée par des vias (97) à une des deuxièmes (96-4, 96-5, 96-6) et à une des quatrièmes (95-1, 95-2, 95-3) zone conductrice du premier niveau.

4. Module selon la revendication 2 ou 3, dans lequel ladite troisième zone conductrice (91) du premier niveau a une forme de Y, chaque branche recevant un desdits deuxièmes interrupteurs.

5. Module selon l'une quelconque des revendications 2 à 4, s'inscrivant dans une forme triangulaire.

6. Module selon l'une quelconque des revendications 2 à 4, dont un troisième niveau du substrat, entre les premier et deuxième niveaux, comporte :
des premières zones conductrices (117-1, 117-2, 117-3) à l'aplomb de chaque premier interrupteur ; et
une deuxième zone conductrice (114) s'étendant sous les trois deuxièmes interrupteurs.

7. Module selon la revendication 6, dont un quatrième niveau du substrat entre les deuxième et troisième niveaux, comporte :
des premières zones conductrices (119-1, 119-2, 119-3) à l'aplomb de chaque premier interrupteur ; et
une deuxième zone conductrice (118) s'étendant sous les trois deuxièmes interrupteurs.

8. Module selon la revendication 1, dans lequel les deuxièmes zones conductrices (72h-1, 72h-2, 72h-3 ; 74l-1, 74l-2, 74l-3) du premier niveau sont chacune reliée, par des vias (73h-1, 73h-2, 73h-3 ; 73l-1, 73l-2, 73l-3), à une desdites premières zones conductrices (81h-1, 81h-2, 81h-3 ; 811-1, 81l-2, 81l-3) du deuxième niveau.

9. Module selon la revendication 8, dans lequel lesdites premières zones conductrices (81h-1, 81h-2, 81h-3 ; 81l-1, 81l-2, 81l-3) du deuxième niveau décrivent un anneau hexagonal.

10. Module selon la revendication 8 ou 9, s'inscrivant dans une forme hexagonale.

11. Module selon l'une quelconque des revendications 1 à 10, dans lequel lesdits interrupteurs sont des transistors MOS.

12. Module selon l'une quelconque des revendications 1 à 11, dans lequel le substrat est un substrat métallique isolé, multiniveaux, de préférence sur céramique.

13. Module selon l'une quelconque des revendications 1 à 12, dans lequel le substrat est un circuit imprimé multiniveaux.

14. Onduleur de courant triphasé, comportant deux modules (2h, 21) selon l'une quelconque des revendications 1 à 13.

15. Onduleur selon la revendication 14, dans lequel les cellules (3h-1, 3h-2, 3h-3 ; 3l-1, 3l-2, 3l-3) des deux modules (2h, 21) sont électriquement connectées deux à deux, les noeuds d'interconnexion définissant trois bornes de phase (15, 16, 17).

## Patentansprüche

1. Dreiphasen-Schaltmodul (2h; 2l), das drei identische Schaltzellen (3h-1, 3h-2, 3h-3; 3l-1, 3l-2, 3l-3) aufweist, die jeweils einen ersten Schalter (M) und einen zweiten Schalter (D; M) aufweisen und zwar elektrisch in Reihe zwischen einem ersten Anschluss (11, 12), der den drei Zellen gemeinsam ist und einem zweiten Anschluss (15, 16, 17), der für jede Zelle spezifisch ist, wobei das Modul ein Substrat aufweist, wovon:
eine erste Ebene Folgendes aufweist:
drei erste leitende Bereiche (71h-1, 71h-2, 71h-3; 71l-1, 71l-2, 71l-3) zum Aufnehmen eines Rückleitungsanschlusses des ersten Schalters (M) und eines Rückleitungsanschlusses des zweiten Schalters (D, M) jeder Zelle; und
drei zweite leitende Bereiche (72h-1, 72h-2, 72h-3; 74l-1, 74l-2, 74l-3) zum Aufnehmen von Drähten zur Verbindung mit einem vorderen Leitungsanschluss des ersten Schalters (M); und
drei dritte leitende Bereiche (74h-1, 74h-2, 74-3) zum Aufnehmen von Drähten zur Verbindung mit einem vorderen Leitungsanschluss des zweiten Schalters (D, M); und
mindestens eine zweite Ebene Folgendes aufweist:
drei erste leitende Bereiche (81h-1, 81h-2, 81h-3; 81l-1, 81l-2, 81l-3), die jeweils mit den dritten leitenden Bereichen (72h-1, 72h-2, 72h-3) der ersten Ebene über Durchkontaktierungen, bzw. vias, (73h-1, 73h-2, 73h-3) verbunden sind, wobei die drei ersten leitenden Bereiche (81h 1, 81h 2, 81h 3; 8111, 81l 2, 81l 3) dazu bestimmt sind, mit jeweiligen zweiten Anschlüssen (15, 16, 17) der Zellen des Moduls verbunden zu werden; und
mindestens ein zweiter leitender Bereich (82h; 82l), der mit den drei dritten leitenden Bereichen (74h-1, 74h-2, 74h-3; 74-3) der ersten Ebene über Durchkontaktierungen, bzw. vias, (75h-1, 75h-2, 75h-3) verbunden ist, wobei der zweite Bereich (82h; 82l) dazu bestimmt ist, mit dem ersten Anschluss (11, 12) des Moduls verbunden zu werden,
wobei die leitenden Bereiche der verschiedenen Ebenen einer Dreh-Symmetrie der 3. Ordnung genügen.

2. Dreiphasen-Schaltmodul (2h; 2l), das drei identische Schaltzellen (3h-1, 3h-2, 3h-3; 3l-1, 3l-2, 3l-3) aufweist, die jeweils einen ersten Schalter (M-4, M-5, M-6) und einen zweiten Schalter (M-1, M-2, M-3) aufweisen und zwar elektrisch in Reihe zwischen einem ersten Anschluss (11, 12), der den drei Zellen gemeinsam ist und einem zweiten Anschluss (15, 16, 17), der für jede Zelle spezifisch ist, wobei das Modul ein Substrat aufweist, wovon:
eine erste Ebene Folgendes aufweist:
drei erste leitende Bereiche (92-4, 92-5, 92-6) zum Aufnehmen eines Rückleitungsanschlusses des ersten Schalters (M-4, M-5, M-6); und
drei zweite leitende Bereiche (96-4, 96-5, 96-6; 96-4, 96-5, 96-6) zum Aufnehmen von Drähten zur Verbindung mit einem vorderen Leitungsanschluss des ersten Schalters (M-4, M-5, M-6); und
wenigstens ein dritter leitender Bereich (91) zum Aufnehmen eines Rückleitungsanschlusses des zweiten Schalters (M-1, M-2, M-3) jeder Zelle; und
drei vierte leitende Bereiche (95-1, 95-2, 95-3) zum Aufnehmen von Drähten zur Verbindung mit einem vorderen Leitungsanschluss des zweiten Schalters (M-1, M-2, M-3) jeder Zelle; und
mindestens eine zweite Ebene Folgendes aufweist:
drei erste leitende Bereiche (101-1, 101-2, 101-3; 113-1, 113-2, 113-3) jeweils in Reihe mit den ersten Schaltern (M-4, M-5, M-6) und die mit den drei ersten leitenden Bereichen (92-4, 92-5, 92-6) der ersten Ebene über Durchkontaktierungen, bzw. vias, (99) verbunden sind, wobei die ersten leitenden Bereiche (101-1, 101-2, 101-3; 113-1, 113-2, 113-3) dazu bestimmt sind, mit jeweiligen zweiten Anschlüssen (15, 16, 17) der Zellen des Moduls verbunden zu werden; und
mindestens ein zweiter leitender Bereich (102; 112-1, 112-2, 112-3), der in Reihe mit den zweiten Schaltern und mit dem dritten leitenden Bereich (91) der ersten Ebene über Durchkontaktierungen, bzw. vias, (94) verbunden ist, wobei der zweite Bereich dazu bestimmt ist, mit dem ersten Anschluss (11, 12) des Moduls verbunden zu werden,
wobei die leitenden Bereiche der verschiedenen Ebenen einer Dreh-Symmetrie der 3. Ordnung genügen.

3. Modul nach Anspruch 2, wobei die zweite Ebene ferner drei dritte leitende Bereiche (103-1, 103-2, 103-3) aufweist, die jeweils über Durchkontaktierungen (97) mit einem der zweiten (96-4, 96-5, 96-6) und einem der vierten (95-1, 95-2, 95-3) leitenden Bereiche der ersten Ebene verbunden sind.

4. Modul nach Anspruch 2 oder 3, wobei der dritte leitende Bereich (91) der ersten Ebene Y-förmig ist und jeder Zweig einen der zweiten Schalter aufnimmt.

5. Modul nach einem der Ansprüche 2 bis 4, enthalten in einer dreieckigen Form.

6. Modul nach einem der Ansprüche 2 bis 4, mit einer dritten Ebene des Substrats zwischen der ersten und der zweiten Ebene, die Folgendes aufweist:
erste leitende Bereiche (117-1, 117-2, 117-3) in Reihe mit jedem ersten Schalter; und
ein zweiter leitender Bereich (114), der sich unter den drei zweiten Schaltern erstreckt.

7. Modul nach Anspruch 6, das eine vierte Ebene des Substrats zwischen der zweiten und dritten Ebene aufweist, die Folgendes aufweist:
erste leitende Bereiche (119-1, 119-2, 119-3) in Reihe mit jedem ersten Schalter; und
ein zweiter leitender Bereich (118), die sich unter den drei zweiten Schaltern erstreckt.

8. Modul nach Anspruch 1, wobei die zweiten leitenden Bereiche (72h-1, 72h-2, 72h-3; 74l-1, 74l-2, 74l-3) der ersten Ebene jeweils über Durchkontaktierungen, bzw. vias, (73h-1, 73h-2, 73h-3; 73l-1, 73l-2, 73l-3) mit einem der ersten leitenden Bereiche (81h-1, 81h-2, 81h-3; 81l-1, 81l-2, 81l-3) der zweiten Ebene verbunden sind.

9. Modul nach Anspruch 8, wobei die ersten leitenden Bereiche (81h-1, 81h-2, 81h-3; 81l-1, 81l-2, 81l-3) der zweiten Ebene einen hexagonalen Ring bilden.

10. Modul nach Anspruch 8 oder 9, das in einer hexagonalen Form enthalten ist.

11. Modul nach einem der Ansprüche 1 bis 10, wobei die Schalter MOS-Transistoren sind.

12. Modul nach einem der Ansprüche 1 bis 11, wobei das Substrat ein mehrschichtig isoliertes Metallsubstrat, vorzugsweise auf Keramik, ist.

13. Modul nach einem der Ansprüche 1 bis 12, wobei das Substrat eine gedruckte Mehrebenenschaltung ist.

14. Drehstrom-Wechselrichter, umfassend zwei Module (2h, 2l) nach einem der Ansprüche 1 bis 13.

15. Wechselrichter nach Anspruch 14, bei dem die Zellen (3h-1, 3h-2, 3h-3; 3l-1, 3l-2, 3l-3) der beiden Module (2h, 2l) paarweise elektrisch verbunden sind, wobei die Verbindungsknoten drei Phasenanschlüsse (15, 16, 17) definieren.

## Claims

1. Three-phase switching module (2h; 2l) including three identical switching cells (3h-1, 3h-2, 3h-3; 3l-1, 3l-2, 3l-3), each including a first switch (M) and a second switch (D; M) electrically in series between a first terminal (11, 12) common to the three cells and a second terminal (15, 16, 17) specific to each cell, the module including a substrate:
a first level of which includes:
three reception first conductive areas (71h-1, 71h-2, 71h-3; 71l-1, 711-2, 71l-3) of a back conduction terminal of the first switch (M) and of a back conduction terminal of the second switch (D, M) of each cell; and
three second conductive areas (72h-1, 72h-2, 72h-3; 74l-1, 74l-2, 74l-3) for receiving wires of connection to a front conduction terminal of said first switch (M); and
three third conductive areas (74h-1, 74h-2, 74-3) for receiving wires of connection to a front conduction terminal of said second switch (D, M); and
at least one second level of which includes:
three first conductive areas (81h-1, 81h-2, 81h-3; 811-1, 81l-2, 81l-3) respectively connected to the third conductive areas (72h-1, 72h-2, 72h-3) of the first level by vias (73h-1, 73h-2, 73h-3) said three first conductive areas (81h 1, 81h 2, 81h 3; 81l 1, 81l 2, 811 3) being intended to be coupled to respective second terminals (15, 16, 17) of the cells of the module; and
at least one second conductive area (82h; 82l) connected to the three third conductive areas (74h-1, 74h-2, 74h-3; 74-3) of the first level by vias (75h-1, 75h-2, 75h-3), said second area (82h; 82l) being intended to be coupled with the first terminal (11, 12) of the module,
the conductive areas of the different levels respecting a symmetry of revolution of order 3.

2. Three-phase switching module (2h; 2l) including three identical switching cells (3h-1, 3h-2, 3h-3; 31-1, 3l-2, 3l-3), each including a first switch (M-4, M-5, M-6) and a second switch (M-1, M-2, M-3) electrically in series between a first terminal (11, 12) common to the three cells and a second terminal (15, 16, 17) specific to each cell, the module including a substrate:
a first level of which includes:
three first conductive areas (92-4, 92-5, 92-6) for receiving a back conduction terminal of the first switch (M-4, M-5, M-6) of each cell; and
three second conductive areas (96-4, 96-5, 96-6; 96-4, 96-5, 96-6) for receiving wires of connection to a front conduction terminal of said first switch (M-4, M-5, M-6); and
at least a third conductive area (91) of reception of a back conduction terminal of the second switch (M-1, M-2, M-3) of each cell; and
three fourth conductive areas (95-1, 95-2, 95-3) for receiving wires of connection to a front conduction terminal of said second switch (M-1, M-2, M-3) of each cell; and
at least one second level of which includes:
three first conductive areas (101-1, 101-2, 101-3; 1l3-1, 113-2, 113-3) respectively in line with the first switches (M-4, M-5, M-6) and connected to the three first conductive areas (92-4, 92-5, 92-6) of the first level by vias (99), said first areas (101-1, 101-2, 101-3; 1l3-1, 1l3-2, 113-3) being intended to be coupled to respective second terminals (15, 16, 17) of the cells of the module; and
at least one second conductive area (102; 112-1, 112-2, 112-3) in line with the second switches and connected to the third conductive area (91) of the first level by vias (94), said second area being intended to be coupled with the first terminal (11, 12) of the module,
the conductive areas of the different levels respecting a symmetry of revolution of order 3.

3. Module according to claim 2, wherein the second level further includes three third conductive areas (103-1, 103-2, 103-3), each coupled by vias (97) with one of the second (96-4, 96-5, 96-6) and one of the fourth (95-1, 95-2, 95-3) conductive areas of the first level.

4. Module according to claim 2 or 3, wherein said third conductive area (91) of the first level is Y-shaped, each branch receiving one of said second switches.

5. Module according to any of claims 2 to 4, contained within a triangular shape.

6. Module according to any of claims 2 to 4, having a third level of the substrate, between the first and second levels, including:
first conductive areas (117-1, 117-2, 117-3) in line with each first switch; and
a second conductive area (114) extending under the three second switches.

7. Module according to claim 6, having a fourth level of the substrate, between the second and third levels, including:
first conductive areas (119-1, 119-2, 119-3) in line with each first switch; and
a second conductive area (118) extending under the three second switches.

8. Module according to claim 1, wherein the second conductive areas (72h-1, 72h-2, 72h-3; 741-1, 741-2, 741-3) of the first level are each coupled, by vias (73h-1, 73h-2, 73h-3; 73l-1, 73l-2, 73l-3), to one of said first conductive areas (81h-1, 81h-2, 81h-3; 811-1, 81l-2, 811-3) of the second level.

9. Module according to claim 8, wherein said first conductive areas (81h-1, 81h-2, 81h-3; 811-1, 811-2, 811-3) of the second level form a hexagonal ring.

10. Module according to claim 8 or 9, contained within a hexagonal shape.

11. Module according to any of claims 1 to 10, wherein said switches are MOS transistors.

12. Module according to any of claims 1 to 11, wherein the substrate is a multilevel insulated metal substrate, preferably on ceramic.

13. Module according to any of claims 1 to 12, wherein the substrate is a multilevel printed circuit.

14. Three-phase current inverter, comprising two modules (2h, 2l) according to any of claims 1 to 13.

15. Inverter according to claim 14, wherein the cells (3h-1, 3h-2, 3h-3; 3l-1, 3l-2, 3l-3) of the two modules (2h, 2l) are electrically connected two by two, the interconnection nodes defining three phase terminals (15, 16, 17).
